# FASCICULE DE BREVET EUROPEEN

(11) **EP 1 062 635 B1**
(45) Date de publication et mention de la délivrance du brevet: **04.12.2002**
(21) Numéro de dépôt: 99939227.7
(22) Date de dépôt: 26.02.1999
(51) Int. Cl.: G06K 19/077

(54) **PROCEDE DE FABRICATION DE CARTES SANS CONTACT**
VERFAHREN ZUR HERSTELLUNG VON KONTAKTLOSEN KARTEN
METHOD FOR MAKING CONTACTLESS CARDS

(30) Priorité: 09.03.1998 FR 9802844
(43) Date de publication de la demande: 27.12.2000
(73) Titulaire: Gemplus, 13881 Gémenos Cedex (FR)
(72) Inventeur: PATRICE, Philippe, F-13190 Allauch (FR)
(86) Numéro de dépôt international: FR9900445
(87) Numéro de publication internationale: WO99046728

(56) Documents cités:
- WO-A-96/07985
- DE-A- 4 431 606
- FR-A- 2 752 077

## Description

La présente invention concerne la fabrication des cartes à puces, et plus particulièrement des cartes capables de fonctionner sans contact à l'aide d'une antenne intégrée dans la carte.

De telles cartes sont destinées à réaliser diverses opérations telles que, par exemple, des opérations bancaires, des communications téléphoniques, des opérations d'identification, des opérations de débit ou de rechargement d'unité de compte, et toutes sortes d'opérations qui peuvent s'effectuer à distance par couplage électromagnétique à haute fréquence entre une borne d'émission-réception et une carte placée dans la zone d'action de cette borne.

Un des problèmes principaux qu'il faut résoudre dans la fabrication de telles cartes est la connexion de l'antenne à la puce de circuit intégré qui assure le fonctionnement électronique de la carte. Un autre problème qu'il faut résoudre est la réduction au maximum de l'épaisseur de la carte. Les contraintes classiques de tenue mécanique, de fiabilité et de coût de fabrication doivent évidemment être prises en compte dans cette fabrication.

Une solution connue de l'art antérieur, décrite dans le document PCT WO 96/07985, pour réaliser la connexion entre l'antenne et la puce de circuit intégré, consiste à former des bossages métalliques sur deux plots de contact de la puce, puis à connecter ces bossages sur les extrémités d'un fil d'antenne. Dans ce cas, le fil d'antenne est un fil de cuivre formé sur un substrat et les bossages sont appliqués sur ce fil d'antenne par compression à chaud.

Cependant, le bloc d'interconnexion ainsi obtenu présente des problèmes de tenue mécanique et de fragilité en traction de la connexion. En effet, lorsque la puce est soumise à des sollicitations mécaniques, les bossages subissent des détériorations affectant la qualité de la connexion électrique. Les sollicitations mécaniques peuvent même aller jusqu'à entraîner la rupture des bossages et, par conséquent, l'arrachage de la puce. Les cartes à puces sans contact réalisées selon ce procédé antérieur présentent donc une durée de vie relativement courte.

Dans une autre solution connue de l'art antérieur, la connexion entre l'antenne et la puce est réalisée par l'intermédiaire de colle conductrice appliquée entre l'antenne et des bossages métalliques formés sur deux plots de contact de la puce. Dans ce cas, cependant, une surépaisseur importante apparaît du fait de la présence de la colle et des bossages. De plus, la fabrication de la carte nécessite une étape supplémentaire de distribution de points de colle.

Les bossages, et le cas échéant les points de colle conductrice, présentent une épaisseur non négligeable qui s'ajoute à celle de l'antenne et celle de la puce, ce qui augmente l'encombrement du bloc d'interconnexion obtenu. Or, on cherche à obtenir un bloc d'interconnexion de très faible encombrement afin de réaliser une carte à puce sans contact ultra plate, c'est à dire d'épaisseur inférieure à l'épaisseur normalisée ISO.

La présente invention permet de résoudre les problèmes rencontrés dans l'art antérieur puisqu'elle propose de fabriquer une carte à puce sans contact dans laquelle la puce est directement connectée à l'antenne au moyen de bossages métallisés qui sont incrustés dans l'épaisseur de l'antenne, au moment du report de la puce sur l'antenne.

L'invention a plus particulièrement pour objet un procédé de fabrication de carte à puce sans contact comportant une puce de circuit intégré et une antenne, dans lequel on réalise des bossages métallisés sur deux plots de contact de la puce, caractérisé en ce que la connexion de la puce à l'antenne est réalisée par incrustation des bossages métallisés dans l'épaisseur de l'antenne, au moment du report de la puce sur ladite antenne.

Grâce au procédé selon l'invention la connexion obtenue entre l'antenne et la puce est de très bonne qualité. En effet, étant donné que les bossages métallisés sont imbriqués dans l'antenne, ils ne risquent pas d'être détériorés, et encore moins rompus, lorsque la carte est soumise à des sollicitations mécaniques. La tenue mécanique de la connexion étant améliorée, les cartes à puces sans contact fabriquées selon ce procédé présentent par conséquent une durée de vie accrue.

De plus, étant donné que les bossages sont incrustés dans l'épaisseur de l'antenne, l'ensemble d'interconnexion formé par la puce et l'antenne présente un encombrement réduit, ce qui est très avantageux pour réaliser une carte ultra plate, d'épaisseur inférieure à 760µm.

De plus, selon une autre caractéristique de l'invention, l'antenne est réalisée dans un matériau apte à présenter un état visqueux au moment du report de la puce, afin de permettre l'incrustation des bossages métallisés.

Ainsi, l'antenne peut être réalisée dans un matériau thermoplastique chargé en particules métalliques et la puce est reportée sur l'antenne par thermocompression. Dans ce cas, la chaleur permet de ramollir le matériau d'antenne et la compression facilite la pénétration des bossages dans l'épaisseur du matériau ramolli.

Selon un autre mode de réalisation, l'antenne peut être réalisée dans un matériau conducteur non polymérisé, puis la puce est reportée sur l'antenne par compression, et un apport de chaleur permet de polymériser le matériau d'antenne. Dans ce cas, avant le report de la puce, l'antenne étant réalisée dans un matériau non polymérisé, elle présente un aspect mou. L'étape de compression permet ensuite de faciliter la pénétration des bossages dans le matériau d'antenne et le chauffage permet, quant à lui, de polymériser le matériau d'antenne afin de le durcir.

Selon un autre mode de réalisation, l'antenne est réalisée dans un matériau polymère conducteur humide et la puce est reportée sur l'antenne par compression. Dans ce cas, le polymère étant encore humide, il présente un aspect visqueux. Une fois que l'incrustation des bossages est réalisée par compression, un séchage à l'air ambiant suffit à durcir le polymère.

Selon encore un autre mode de réalisation, l'antenne est réalisée dans un matériau thermoplastique chargé en particules métalliques, la puce est préalablement collée sur une feuille isolante au format de la carte à puce à réaliser, puis la connexion de la puce à l'antenne est réalisée par lamination à chaud. Dans ce cas aussi, la chaleur permet de ramollir le matériau d'antenne tandis que la lamination permet de faciliter la pénétration des bossages dans le matériau ramolli.

D'autres particularités et avantages de l'invention apparaîtront à la lecture de la description donnée à titre d'exemple illustratif et non limitatif et faite en référence aux figures annexées qui représentent :
- les figures 1a et 1b des schémas en coupe du montage d'une puce au cours de sa connexion à une antenne,
- les figures 2a et 2b, des schémas en coupe du montage d'une puce au cours de sa connexion à une antenne, selon un autre mode de réalisation.

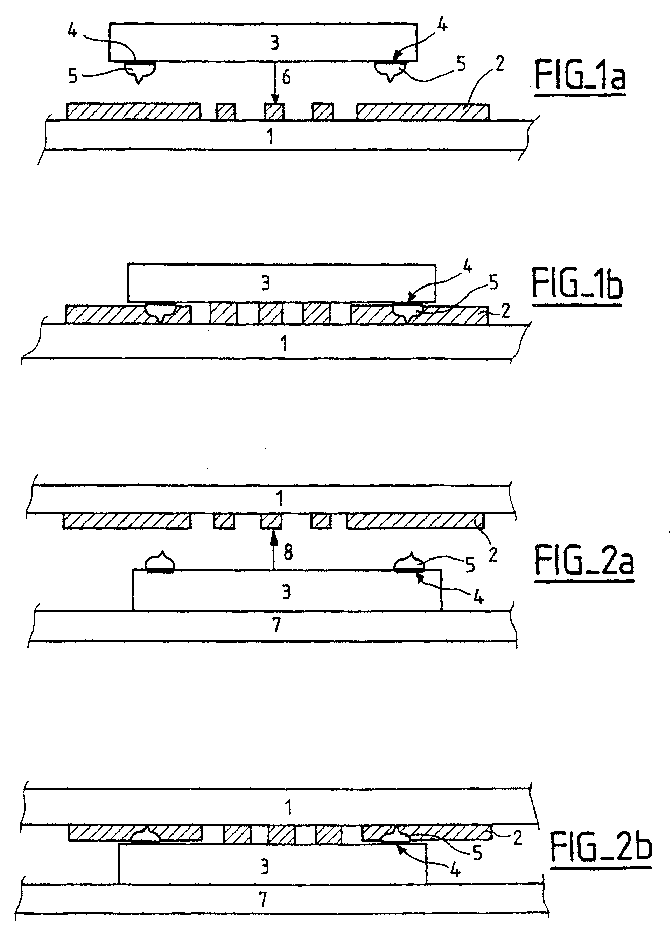

Sur les figures 1a et 1b on a représenté une puce 3 au cours de son montage sur une antenne 2. L'ensemble d'interconnexion formé par la puce 3 et l'antenne 2 est destiné à être inséré dans une carte à puce sans contact d'épaisseur ultra fine et inférieure à l'épaisseur normalisée ISO.

Une étape préliminaire du procédé de fabrication selon l'invention consiste à former des bossages métallisés 5 sur des plots de contact 4 de la puce 3. Les bossages 5 sont destinés à assurer la connexion électrique entre la puce 3 et l'antenne 2. Ils sont par conséquent nécessairement réalisés dans un matériau conducteur. Ils peuvent par exemple être réalisés en or, ou alors dans un matériau polymère chargé en particules métalliques.

De préférence les bossages 5 sont réalisés sur deux plots de contact 4 de la puce afin de pouvoir réaliser une connexion sur des plages conductrices de l'antenne 2 situées à ses extrémités.

Étant donné que les bossages 5 sont destinés à s'incruster dans l'épaisseur de l'antenne 2, ils présentent de préférence une épaisseur environ égale, ou légèrement inférieure, à celle de l'antenne.

De plus, pour permettre une bonne pénétration des bossages 5 dans l'épaisseur de l'antenne 2, on leur préfère une forme sensiblement conique.

L'antenne 2, quant à elle, est réalisée sur un substrat 1 isolant. Elle est réalisée dans un matériau conducteur apte à être ramolli au moment du report de la puce 3, afin de permettre une meilleure pénétration des bossages 5. Sa forme importe peu, elle peut par exemple représenter une spirale ou tout autre motif.

Le substrat isolant 1 est par exemple une feuille plastique au format de la carte à puce à réaliser. Il peut par exemple être composé de polychlorure de vinyle (PVC) ou de polyéthylène (PE).

Un premier mode de réalisation consiste à réaliser l'antenne 2 dans un matériau thermoplastique chargé en particules métalliques. Ce matériau est par exemple fourni par la société AIT sous la référence LZTP 8550-FT. L'antenne est formée dans ce cas par sérigraphie d'encre conductrice à base thermoplastique. Les particules métalliques sont par exemple constituées par des petites billes d'argent. Dans ce cas, l'étape ultérieure consistant à reporter la puce 3 sur l'antenne 2 est réalisée par compression 6 à chaud. Le fait de chauffer permet en effet de ramollir le matériau thermoplastique constituant l'antenne 2, et la compression simultanée permet de faciliter la pénétration des bossages 5 dans l'épaisseur de l'antenne en vue de réaliser la connexion de la puce 3 à l'antenne 2. Lorsque l'opération de thermocompression est terminée, on laisse l'ensemble d'interconnexion obtenu refroidir à l'air ambiant. Le refroidissement permet au matériau d'antenne de retrouver son état solide et sa forme initiale. L'antenne thermoplastique présente généralement des propriétés adhésives au cours de son ramollissement qui permettent de fixer la puce.

Une autre feuille plastique au format de la carte à puce à réaliser, non représentée sur les figures 1a et 1b, peut ensuite être appliquée au dessus de l'ensemble d'interconnexion obtenu et fixée par collage, pour enfermer la puce et l'antenne et former ainsi une carte sans contact.

Grâce à ce procédé de fabrication, on réalise la connexion de la puce 3 à l'antenne 2, par incrustation des bossages 5 dans l'antenne 2, et la fixation de la puce 3 sur l'antenne 2 en une seule et même étape.

Dans une variante de réalisation, l'antenne 2 est réalisée dans un matériau polymère thermodurcissable conducteur, c'est à dire chargé de particules métalliques. Dans ce cas, on fait en sorte de ne pas polymériser le matériau d'antenne avant l'étape du report de la puce sur l'antenne, de manière à ce que ce matériau se présente dans un état visqueux, par exemple, compris entre 8000 CPS et 6000 CPS. La puce 3 est ensuite reportée par compression 6, afin de faciliter la pénétration des bossages 5 dans l'épaisseur du matériau d'antenne. Un apport de chaleur permet en outre de polymériser le matériau d'antenne 2 afin qu'il durcisse. Cette opération de chauffage peut être indifféremment réalisée après ou simultanément à l'opération de compression. Dans ce cas aussi, on réalise la connexion électrique entre la puce et l'antenne et la fixation de la puce sur l'antenne en une seule étape.

Dans une autre variante de réalisation, l'antenne 2 est réalisée dans un matériau polymère conducteur non séché. Dans ce cas, le fait que le polymère soit humide suffit à ce qu'il garde un aspect mou. La puce 3 peut alors être reportée sur l'antenne 2 par compression 6 afin de faciliter la pénétration des bossages métallisés 5 dans l'épaisseur du matériau d'antenne. Il suffit ensuite de laisser sécher le bloc d'interconnexion obtenu à l'air ambiant, afin que le matériau d'antenne durcisse. Dans ce cas, un apport de chaleur n'est alors pas nécessaire.

Les figures 2a et 2b représentent un autre mode de réalisation d'un montage d'une puce 3 connectée à une antenne 2. Sur ces figures les mêmes références que sur les figures 1a et 1b ont été reprises pour désigner les mêmes éléments. Dans ce mode de réalisation, l'antenne 2 est également réalisée sur un substrat 1 isolant, telle qu'une feuille plastique par exemple, au format de la carte à puce à réaliser. L'antenne 2 est réalisée dans un matériau thermoplastique chargé en particules métalliques. Des bossages métallisés 5 sont également formés sur les plots de contact 4 de la puce 3.

Cependant, ce mode de réalisation diffère des précédents dans le fait que l'étape du report de la puce 3 sur l'antenne 2 n'est pas réalisée de la même manière.

En effet, dans l'exemple des figures 2a et 2b, une étape préliminaire supplémentaire consiste à coller la puce 3 sur un substrat isolant 7. Ce substrat 7 est par exemple une feuille plastique en polychlorure de vinyle (PVC) ou en polyéthylène (PET) au format de la carte que l'on veut réaliser. Dans ce cas, on colle donc, sur le substrat 7, la face arrière non active de la puce 3, c'est à dire la face opposée à celle qui porte les plots de contact 4 et les bossages métallisés 5.

Ainsi, la puce 3 et l'antenne 2 sont disposées entre deux feuilles plastiques 1 et 7, de préférence réalisées au format de la carte que l'on souhaite fabriquer.

Le report de la puce 3 sur l'antenne 2 et l'interconnexion électrique sont ensuite réalisés au cours d'une opération de lamination 8 à chaud des deux feuilles plastiques 1 et 7. La chaleur permet en effet de ramollir le matériau thermoplastique constitutif de l'antenne tandis que la lamination, consistant à presser les deux feuilles plastiques 1 et 7 l'une contre l'autre, permet de faciliter la pénétration des bossages 5 dans le matériau d'antenne ramolli.

Lorsque l'opération de lamination à chaud est terminée, l'ensemble d'interconnexion obtenu est laissé à refroidir de manière à ce que le matériau d'antenne 2 retrouve son état solide initial. La puce 3 et l'antenne 2 sont alors interconnectées et enfermées entre deux feuilles plastiques 1 et 7, formant ainsi une carte à puce sans contact.

Grâce au procédé de fabrication selon l'invention, il est possible de fabriquer des cartes à puce sans contact d'épaisseur ultra fine et inférieure à 760µm. L'épaisseur de la carte obtenue est en effet égale à la somme des épaisseurs des deux feuilles plastiques 1 et 7, de la puce 3 et de l'antenne 2. Des ordres de grandeur de ces épaisseurs sont donnés à titre purement illustratif ci-après. L'antenne 2 peut être réalisée sur une épaisseur comprise entre 20 et 30µm, la puce de circuit intégré 3 peut être réalisée sur une épaisseur inférieure à 300µm et les feuilles plastiques 1 et 7 peuvent être réalisées sur une épaisseur comprise entre 40 et 100µm.

De plus, les bossages 5 étant complètement incrustés dans l'épaisseur de l'antenne 2, ils ne risquent pas d'être détériorés par des sollicitations mécaniques. L'ensemble d'interconnexion obtenu présente donc une très bonne tenue mécanique et une durée de vie accrue.

## Revendications

1. Procédé de fabrication de carte à puce sans contact comportant une puce de circuit intégré (3) et une antenne (2), dans lequel on réalise des bossages métallisés (5) sur deux plots de contact (4) de la puce (3), **caractérisé en ce que** la connexion de la puce (3) à l'antenne (2) est réalisée par incrustation des bossages métallisés (5) dans l'épaisseur de l'antenne (2), au moment du report de la puce (3) sur ladite antenne (2).

2. Procédé selon la revendication 1, **caractérisé en ce que** l'antenne (2) est réalisée dans un matériau apte à présenter un état visqueux au moment du report de la puce (3), afin de permettre l'incrustation des bossages métallisés (5).

3. Procédé selon l'une des revendications 1 à 2, **caractérisé en ce que** l'antenne (2) est réalisée sur un substrat (1) isolant au format de la carte à puce.

4. Procédé selon l'une des revendications 1 à 3, **caractérisé en ce que** l'antenne (2) est réalisée dans un matériau thermoplastique chargé en particules métalliques et **en ce que** la puce (3) est reportée sur l'antenne par thermocompression.

5. Procédé selon l'une des revendications 1 à 3, **caractérisé en ce que** l'antenne (2) est réalisée dans un matériau conducteur non polymérisé, puis la puce (3) est reportée sur l'antenne (2) par compression, et **en ce qu'**un apport de chaleur permet de polymériser le matériau d'antenne.

6. Procédé selon l'une des revendications 1 à 3, **caractérisé en ce que** l'antenne est réalisée dans un matériau polymère conducteur humide, et **en ce que** la puce (3) est reportée sur l'antenne (2) par compression.

7. Procédé selon l'une des revendications 1 à 3, **caractérisé en ce que** l'antenne (2) est réalisée dans un matériau thermoplastique chargé en particules métalliques, la puce (3) est préalablement collée sur une feuille (7) isolante au format de la carte à puce, et **en ce que** la connexion de la puce (3) à l'antenne (2) est réalisée par lamination à chaud.

8. Procédé selon l'une des revendications 1 à 7, **caractérisé en ce que** les bossages métallisés (5) présentent une forme sensiblement conique.

## Claims

1. A method for manufacturing a contactless smart card containing an integrated circuit chip (3) and an antenna (2), in which metallised bumps (5) are produced on two contact pads (4) on the chip (3), **characterised in that** the connection of the chip (3) to the antenna (2) is effected by embedding metallised bumps (5) in the thickness of the antenna (2), at the time the chip (3) is attached to the said antenna (2).

2. A method according to Claim 1, **characterised in that** the antenna (2) is produced from a material able to exhibit a viscous state at the time the chip (3) is attached, to allow the embedding of the metallised bumps (5).

3. A method according to one of Claims 1 to 2, **characterised in that** the antenna (2) is produced on an insulating substrate (1) to the format of the smart card.

4. A method according to one of Claims 1 to 3, **characterised in that** the antenna (2) is produced from a thermoplastic material loaded with metallic particles and **in that** the chip (3) is attached to the antenna by thermocompression.

5. A method according to one of Claims 1 to 3, **characterised in that** the antenna (2) is produced from a non-polymerised conductive material, and then the chip (3) is attached to the antenna (2) by compression, and **in that** an addition of heat polymerises the antenna material.

6. A method according to one of Claims 1 to 3, **characterised in that** the antenna is produced from a wet conductive polymer material, and **in that** the chip (3) is attached to the antenna (2) by compression.

7. A method according to one of Claims 1 to 3, **characterised in that** the antenna (2) is produced from a thermoplastic material containing metallic particles and the chip (3) is glued in advance to an insulating sheet (7) to the format of the smart card, and **in that** the connection of the chip (3) to the antenna (2) is effected by hot lamination.

8. A method according to one of Claims 1 to 7, **characterised in that** the metallised bumps (5) have a substantially conical shape.

## Patentansprüche

1. Herstellungsverfahren einer kontaktlosen Chipkarte mit einem IC-Chip (3) und einer Antenne (2), bei dem man an zwei Kontaktstiften (4) des Chips (3) metallisierte Höcker (5) herstellt, **dadurch gekennzeichnet, dass** der Anschluss des Chips (3) an die Antenne (2) bei der Übertragung des Chips (3) auf die besagte Antenne (2) durch Einbetten der metallisierten Höcker (5) in die Dicke der Antenne (2) durchgeführt wird.

2. Verfahren nach Anspruch 1, **dadurch gekennzeichnet, dass** die Antenne (2) aus einem Material besteht, das bei der Übertragung des Chips (3) einen viskösen Zustand aufweisen kann, um das Einbetten der metallisierten Höcker (5) zu ermöglichen.

3. Verfahren nach einem der Ansprüche 1 bis 2, **dadurch gekennzeichnet, dass** die Antenne (2) auf einem isolierenden Substrat (1) im Format der Chipkarte realisiert ist.

4. Verfahren nach einem der Ansprüche 1 bis 3, **dadurch gekennzeichnet, dass** die Antenne (2) aus einem mit Metallpartikeln verstärkten Thermoplast-Material besteht, und dass der Chip (3) durch Thermokompression auf die Antenne übertragen wird.

5. Verfahren nach einem der Ansprüche 1 bis 3, **dadurch gekennzeichnet, dass** die Antenne (2) aus einem leitenden, nicht polymerisierten Material besteht, dass der Chip (3) durch Kompression auf die Antenne (2) übertragen wird, und dass eine Wärmezufuhr ermöglicht, das Antennenmaterial zu polymerisieren.

6. Verfahren nach einem der Ansprüche 1 bis 3, **dadurch gekennzeichnet, dass** die Antenne aus einem feuchten leitenden Polymer-Material besteht, und dass der Chip (3) durch Kompression auf die Antenne (2) übertragen wird.

7. Verfahren nach einem der Ansprüche 1 bis 3, **dadurch gekennzeichnet, dass** die Antenne (2) aus einem mit Metallpartikeln verstärkten Thermoplast-Material besteht, dass der Chip (3) zuvor auf eine isolierende Folie (7) im Format der Chipkarte geklebt wird, und dass der Anschluss des Chips (3) an die Antenne (2) durch Warmwalzen erfolgt.

8. Verfahren nach einem der Ansprüche 1 bis 7, **dadurch gekennzeichnet, dass** die metallisierten Höcker (5) eine etwa konische Form aufweisen.
